# EUROPÄISCHE PATENTSCHRIFT

(11) **EP 1 189 341 B1**
(45) Veröffentlichungstag und Bekanntmachung des Hinweises auf die Patenterteilung: **22.02.2012**
(21) Anmeldenummer: 01119337.2
(22) Anmeldetag: 10.08.2001
(51) Int. Cl.: H03F 1/52, H03F 3/45

(54) **Verstärkerschaltung**
Amplifier circuit
Circuit amplificateur

(30) Priorität: 08.09.2000 DE 10044452
(43) Veröffentlichungstag der Anmeldung: 20.03.2002
(73) Patentinhaber: Finisar Corporation, Sunnyvale, CA 94089 (US)
(72) Erfinder: Donig, Günter, 85586 Poing (DE)
(74) Vertreter: Müller, Wolfram Hubertus

(56) Entgegenhaltungen:
- EP-A- 0 473 901
- JP-A- 08 185 234
- US-A- 6 107 885
- ED HOLLAND: "D/A Convertor on a budget" HI-FI WORLD SUPPLEMENT, Nr. 38, August 1998 (1998-08), Seiten 27-30, XP002271261
- DATASHEET (PG. 1-12): "LM78LXX Series 3-Terminal Positive Regulators" Februar 1995 (1995-02) , NATIONAL SEMICONDUCTOR XP002271262 * Seite 9 *
- DATASHEET (PG. 1-7): "NE5534, NE5534A, SE5534, SE5534A Low-noise operational amplifiers" September 1990 (1990-09) , TEXAS INSTRUMENTS XP002271263 * Seite 2 *

## Beschreibung

Die vorliegende Erfindung betrifft eine Verstärkerschaltung.

Endstufen werden beispielsweise in der Hochfrequenztechnik mit bipolaren Transistoren realisiert.

Bei Transistoren werden verschiedene Grenzdaten angegeben, welche nicht überschritten werden dürfen, wie beispielsweise bei Bipolartransistoren die Emitter-Basis-Sperrspannung, die maximal zulässige Kollektor-Emitter-Spannung sowie die Kollektor-Basis-Sperrspannung. Wird beispielsweise die maximal zulässige Kollektor-Emitter-Spannung aufgrund von hoher Versorgungsspannung überschritten, so treten unerwünschte Durchbruchseffekte auf. Hierbei fließen bei verringerter Ausgangsleistung signifikant größere Ströme. Diese Durchbruchseffekte haben den Nachteil, daß der Durchbruch, sobald er einmal angestoßen ist, nicht mehr abreißt.

Es ergibt sich folglich die Forderung, daß die Betriebsspannung in jedem Betriebszustand unterhalb der maximal zulässigen Kollektor-Emitter-Spannung liegen muß. Wenn die Betriebsspannung, beispielsweise durch die Batteriespannung eines portablen Gerätes, vorgegeben ist, und beispielsweise in Abhängigkeit vom Ladezustand der Batterie schwanken kann, so ist es erforderlich, die Verstärkerschaltung für höhere Versorgungsspannungen zu ertüchtigen.

Es ist beispielsweise denkbar, Leistungstransistoren mit höherer Kollektor-Emitter-Durchbruchsspannung zu verwenden. Diese haben jedoch den Nachteil, daß aufwendige Prozeßmodifikationen in der Fertigung erforderlich sind und können nur mit deutlich größerer Chipfläche bei geringerer Leistungsfähigkeit (performance), insbesondere kleinerem Wirkungsgrad, realisiert werden.

In dem Dokument US 4,353,037 ist eine Schutzbeschaltung für einen Sendeverstärker angegeben. Dort wird die Verstärkung des Verstärkers geregelt, um Fehlanpassungen desselben zu vermeiden.

Aufgabe der vorliegenden Erfindung ist es, eine Verstärkerschaltung anzugeben, welche für höhere Versorgungsspannungen geeignet ist, bei der die geschilderten Durchbruchseffekte vermieden werden, und die mit Standardtransistoren ohne erhöhte maximal zulässige Kollektor-Emitter-Spannung U_{CE0} realisierbar ist.

Erfindungsgemäß wird die Aufgabe von einer Text des Anspruchs 1 ohne Bezugszeichen.

Gemäß der Erfindung ist ein Längsregler bezugspotentialseitig, das heißt masseseitig an einer Verstärkerstufe, beispielsweise an einer Hochfrequenzendstufe, vorgesehen. Hierdurch kann in Abhängigkeit von der Regelspannung die über der Verstärkerstufe abfallende, von der Versorgungsspannung abhängige Spannung reduziert werden, so daß keine Durchbruchseffekte in Transistoren der Verstärkerschaltung auftreten. Da die über den Transistoren der Verstärkerstufe abfallende Spannung reduziert ist, wird keine Hochvolt-Bipolar- oder Hochvolt-CMOS-Technologie benötigt, so daß die beschriebene Verstärkerschaltung mit geringem Aufwand, geringem Flächenbedarf und kostengünstig herstellbar ist. Für die Arbeitsfrequenz der Verstärkerstufe, welche hochfrequent sein kann, steht dennoch ein großer Aussteuerbereich zur Verfügung. Dies kann zumindest teilweise durch parasitäre Transistorkapazitäten bedingt sein.

Weiterhin ist gemäß vorliegendem Prinzip ein Spannungsregler vorgesehen, der mit einem Versorgungspotentialanschluß verbunden ist und an seinem Ausgang die Regelspannung bereitstellt, welche eine feste Potentialdifferenz zum Versorgungspotential aufweist. Dieser Spannungsregler bildet zwischen dem Versorgungspotential, welches auch die Verstärkerstufe versorgt, und dem Potential am Bezugsknoten eine feste Potentialdifferenz. Mit dem Spannungsregler ist folglich die über der Verstärkerstufe maximal abfallende Spannung einstellbar, so daß hierdurch gewährleistet ist, daß über der Verstärkerstufe keine Spannung abfällt, welche höher als die maximal zulässige Kollektor-Emitter-Spannung ist. Ist die Versorgungsspannung hingegen kleiner als die fest eingestellte Potentialdifferenz, welche eine feste maximale Potentialdifferenz ist, so wird der steuerbare Widerstand niederohmig und zieht den Bezugsknoten gleichspannungsmäßig praktisch auf Bezugspotential.

Die vorliegende Schaltung begrenzt folglich die über der Ausgangsstufe eines Verstärkers abfallende Spannung auf einen Maximalwert.

In einer vorteilhaften Ausführungsform der vorliegenden Erfindung weist der Längsregler einen mit der Regelspannung steuerbaren Widerstand auf, der einerseits mit dem Bezugsknoten und andererseits mit dem Bezugspotentialanschluß verbunden ist. Dies hat den Vorteil einer leistungslosen Steuerung.

In einer weiteren vorteilhaften Ausführungsform der vorliegenden Erfindung ist der steuerbare Widerstand ein MOS-Transistor. Insbesondere N-Kanal-Transistoren ermöglichen eine Realisierung des Längsreglers mit einer geringen Restspannung, d.h. daß bei geringer Versorgungsspannung der Verstärkerstufe lediglich ein sehr geringer Spannungsbetrag über der in diesem Fall niederohmigen Laststrecke des MOS-Transistors abfällt. Aufgrund von parasitären Kapazitäten im Transistor liegt für die Arbeitsfrequenz auch bei hoher Versorgungsspannung der Bezugsknoten nahezu auf Bezugspotential. Die leistungslose Ansteuerung des MOS-Transistors ermöglicht den Einsatz einer Reglerschaltung mit geringem Strombedarf.

In einer weiteren vorteilhaften Ausführungsform der vorliegenden Erfindung ist im Längsregler eine Regelschleife gebildet, welche einen ersten Operationsverstärker umfaßt, dem an seinem invertierenden Eingang die Regelspannung zuführbar ist, und der mit seinem nicht-invertierenden Eingang mit dem Bezugsknoten verbunden ist, wobei ein Ausgang des ersten Operationsverstärkers mit einem Steuereingang des steuerbaren Widerstandes zu dessen Steuerung gekoppelt ist. Mit der beschriebenen Regelschleife ist ein Spannungsfolger realisiert, bei dem das Potential am Bezugsknoten dem Potential am invertierenden Eingang des ersten Operationsverstärkers, d.h. der Regelspannung, folgt.

In einer weiteren vorteilhaften Ausführungsform der vorliegenden Erfindung ist zwischen Ausgang des ersten Operationsverstärkers und Steuereingang des steuerbaren Widerstands ein Schleifenfilter vorgesehen. Das Schleifenfilter ermöglicht einen stabilen Betrieb der Regelschleife mit einer ausreichenden Phasenreserve auch dann, wenn der erste Operationsverstärker ein nichtidealer Operationsverstärker ist.

In einer weiteren vorteilhaften Ausführungsform der vorliegenden Erfindung ist zur Spannungsregelung ein zweiter Operationsverstärker vorgesehen, dem an seinem nicht-invertierenden Eingang ein Referenzsignal zuführbar ist, dessen Ausgang auf seinen invertierenden Eingang rückgekoppelt ist, und dessen Eingänge mit dem Versorgungspotentialanschluß gekoppelt sind. Mit dem zweiten Operationsverstärker ist in einfacher Weise eine in festem Bezug zum Versorgungspotential stehende Regelspannung bereitstellbar.

In einer weiteren vorteilhaften Ausführungsform der vorliegenden Erfindung ist zur Spannungsregelung ein weiterer steuerbarer Widerstand vorgesehen, dessen Steuereingang mit dem Ausgang des zweiten Operationsverstärkers verbunden ist, und über dessen gesteuerter Strecke, welche einerseits mit dem Bezugspotentialanschluß verbunden ist, die Regelspannung ableitbar ist.

Wenn der steuerbare Widerstand beispielsweise ein MOS-Transistor ist, so ist der Betrieb der Spannungsregelung mit sehr kleiner Restspannung möglich, so daß bei geringer Versorgungsspannung das dem invertierenden Eingang des ersten Operationsverstärkers zuführbare Potential der Regelspannung bis nahezu Bezugspotential reduzierbar ist.

In einer weiteren vorteilhaften Ausführungsform der vorliegenden Erfindung ist zwischen Bezugsknoten und Bezugspotentialanschluß ein Resonanzkreis geschaltet. Mit dem Resonanzkreis steht eine verbesserte Anbindung des Bezugsknotens niederohmig an das Bezugspotential für die Arbeitsfrequenz der Verstärkerstufe zur Verfügung. Hierdurch können die Verstärkungseigenschaften der Verstärkerschaltung verbessert sein.

In einer weiteren vorteilhaften Ausführungsform der vorliegenden Erfindung weist der Resonanzkreis eine Induktivität in Serie zu einer Kapazität auf. Die Kapazität kann dabei mit einem externen Kondensator, welcher über einen Bonddraht, der die Induktivität realisiert, mit dem Bezugsknoten verbunden ist, in einfacher Weise hergestellt sein.

Weitere Einzelheiten der Erfindung sind in den Unteransprüchen angegeben.

Die Erfindung wird nachfolgend an Ausführungsbeispielen anhand der Zeichnungen näher erläutert. Es zeigen:
- Figur 1: eine beispielhafte Realisierung der Verstärker- schaltung anhand eines vereinfachten Blockschalt- bildes und
- Figur 2: eine Weiterbildung des Ausführungsbeispiels von Fi- gur 1 mit einem Eintakt-Ausgang.

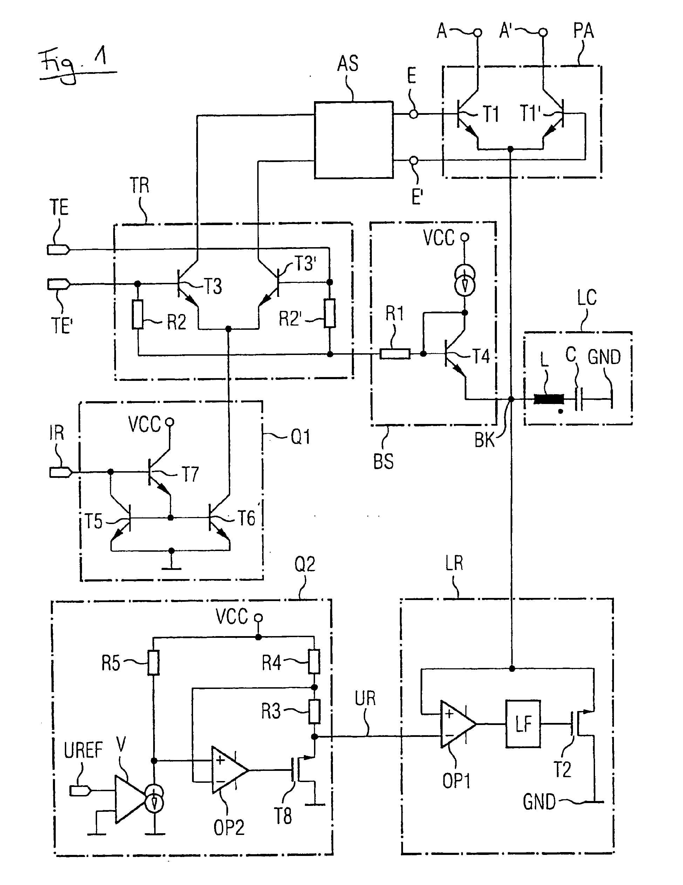

Die Figur 1 zeigt eine Verstärkerstufe PA, der eine Treiberstufe TR vorgeschaltet ist. Um die Treiberstufe TR potentialmäßig an den Bezugsknoten BK anzubinden, ist eine Bias-Schaltung BS vorgesehen. An den Bezugsknoten BK ist weiterhin ein Längsregler LR angeschlossen, der zudem an das Bezugspotential GND angeschlossen ist. Der Längsregler LR weist einen als MOS-Transistor T2 ausgeführten steuerbaren Widerstand auf, der einerseits mit dem Bezugsknoten BK und andererseits mit dem Bezugspotentialanschluß GND verbunden ist.

Um den vollen Aussteuerbereich der Verstärkerstufe PA auch dann zu erhalten, wenn die im Längsregler LR vorhandenen parasitären Kapazitäten nicht für die gewünschte, bezüglich der Arbeitsfrequenz bestehende Anbindung des Bezugsknotens BK auf Bezugspotential GND ausreichen, ist ein Resonanzkreis LC mit einer Induktivität L, welche einerseits mit dem Bezugsknoten BK und andererseits mit einer Kapazität C verbunden ist, die mit dem Bezugspotentialanschluß GND gekoppelt ist, vorgesehen.

Die Figur 1 zeigt eine zur Verstärkung differentieller Signale geeignete Schaltung. Hierfür sind sowohl die Treiberstufe TR als auch die Verstärkerstufe PA symmetrisch ausgeführt, wobei in der Treiberstufe TR zwei dritte emittergekoppelte Transistoren T3, T3' und in der Verstärkerstufe PA zwei erste emittergekoppelte Transistoren T1, T1' vorgesehen sind. Zwischen Treiberstufe TR und Verstärkerstufe PA ist eine Anpaßschaltung AS vorgesehen, welche zur Anpassung von Impedanzen und Spannungspegeln geeignet ist. An die Emitter der ersten Transistoren T1, T1' ist ein als steuerbarer Widerstand betriebener MOS-Transistor T2 angeschlossen, welcher weiterhin mit dem Bezugspotentialanschluß GND verbunden ist. Zur leistungslosen Regelung des Gate-Potentials des zweiten Transistors T2 weist der Längsregler LR einen ersten Operationsverstärker OP1 auf, dem an seinem nicht-invertierenden Eingang das Potential des Bezugsknotens BK und an seinem invertierenden Eingang eine Regelspannung UR zuführbar ist. Mittels eines Schleifenfilters LF ist das Gate des zweiten Transistors an den Ausgang des ersten Operationsverstärkers OP1 gekoppelt. Das Schleifenfilter LF dient dabei zur Bereitstellung einer stabilen Regelschleife, welche eine ausreichende Phasenreserve aufweist. Insgesamt ist mit der Regelschleife im Längsregler LR ein Spannungsfolger gebildet, bei dem das Potential am Bezugsknoten BK dem der Regelspannung UR folgt.

Die Spannungsquelle Q2 zur Bereitstellung der Regelspannung UR weist einen zweiten Operationsverstärker OP2 auf, dessen nicht-invertierender Eingang zum einen mit einem Anschluß zur Zuführung einer Referenzspannung UREF, beispielsweise einer Bandgap-Spannung, und zum anderen über einen fünften Widerstand R5 mit dem Versorgungspotential VCC gekoppelt ist, und dessen invertierender Eingang zum einen über einen vierten Widerstand R4 ebenfalls mit dem Versorgungspotentialanschluß VCC und zum anderen über einen dritten Widerstand R3 einerseits an eine gesteuerte Strecke eines achten Transistors T8 angeschlossen ist, welche andererseits mit dem Bezugspotentialanschluß GND verbunden ist. Der Ausgang des zweiten Operationsverstärkers OP2 ist dabei mit dem Gate-Anschluß des achten Transistors verbunden. Zur Zuführung einer Referenzspannung UREF an den zweiten Operationsverstärker OP2 ist weiterhin ein Verstärker V vorgesehen.

Die Regelspannung UR, welche von der Spannungsquelle Q2 bereitgestellt wird, kann maximal um einen Spannungsbetrag unterhalb des Versorgungspotentials VCC liegen, welcher mit drittem Widerstand R3 und viertem Widerstand R4 einstellbar ist, und sich aus dem Quotienten aus der Summe von drittem und viertem Widerstandswert und dem hindurch fließenden Strom ergibt. Wird die Versorgungsspannung, welche am Versorgungspotentialanschluß VCC eingeprägt wird, langsam vom Bezugspotential GND ausgehend erhöht, so sind zunächst Regelspannung UR und Bezugspotential GND praktisch gleich. Erst dann, wenn die Spannung am Versorgungspotentialanschluß VCC einen bestimmten Wert überschreitet, welcher einstellbar ist und von der maximal zulässigen Kollektor-Emitter-Spannung der zu schützenden Verstärkerstufe PA und der Treiberstufe TR abhängt, sind Regelspannung UR und Spannung am Bezugspotential GND verschieden, wobei zwischen Bezugspotential VCC und Regelspannung UR der feste Spannungsbetrag abfällt. Folglich ist die Regelspannung UR und damit über den Spannungsfolger im Längsregler LR auch der Bezugsknoten BK potentialmäßig an das Versorgungspotential VCC angebunden. Somit kann über der Verstärkerstufe PA, welche mit ihren Ausgängen A, A' mit dem Versorgungspotentialanschluß VCC gekoppelt ist, lediglich ein einstellbarer maximaler Spannungsbetrag abfallen. Demnach können Durchbruchseffekte in den ersten Transistoren T1, T1' in der Verstärkerstufe PA wirksam verhindert werden.

Die Ausführung des achten Transistors T8 als N-Kanal-MOS-Transistor hat den Vorteil, daß bei geringem Versorgungspotential VCC die Regelspannung UR praktisch bis auf Bezugspotential GND reduzierbar ist und über achtem Transistor T8 lastseitig nur eine sehr geringe Restspannung abfällt. Hierfür ist es erforderlich, daß der sogenannte On-Widerstand des achten Transistors T8 klein gegen die Summe aus drittem und viertem Widerstand ist. N-Kanal-Transistoren haben dabei den zusätzlichen Vorteil des geringen Flächenbedarfs.

Zum Betrieb der Treiberstufe TR sind eine Bias-Stufe BS und eine Stromquelle Q1 vorgesehen. Die Stromquelle Q1, welcher ein Referenzstrom IR zuführbar ist, und welche mit dem Bezugspotentialanschluß VCC verbunden ist, stellt die für eine in der Treiberstufe TR realisierte Differenzverstärkerstufe T3, T3' erforderliche Stromquelle dar, welche mit den beiden Emitteranschlüssen der dritten Transistoren T3, T3' verbunden ist. Die Bias-Stufe BS stellt für die dritten Transistoren T3, T3' an deren Basisanschlüssen je eine Bias-Spannung bereit, und weist einen vierten Transistor T4 auf, der einerseits mit dem Bezugsknoten BK und andererseits mit dem Versorgungspotential VCC sowie über einen ersten Widerstand R1 und zweite Widerstände R2, R2' mit der Treiberstufe TR gekoppelt ist.

Um beim Anlegen eines hochfrequenten Eingangssignals an die Eingänge TE, TE' der Treiberstufe TR hohe Verstärkungsfaktoren an den Ausgängen A, A' der Verstärkerstufe PA zu erzielen, ist an den Bezugsknoten BK ein Resonanzkreis LC angeschlossen. Dieser weist eine Induktivität L in Serie zu einer Kapazität C auf, und ist mit dem Bezugspotentialanschluß GND verbunden. Die Kapazität C kann dabei eine externe Kapazität sein, wobei die Induktivität L durch einen Bond-Draht zur Verbindung des Bezugsknotens BK mit der externen Kapazität C realisiert sein kann. Sofern die parasitären Kapazitäten im Längsregler LR ausreichen, um für die an die Eingänge TE, TE' anlegbare Arbeitsfrequenz der Verstärkerschaltung eine Anbindung des Bezugsknotens BK an das Bezugspotential GND zu ermöglichen, kann der Resonanzkreis LC entfallen.

Sowohl zweiter Transistor T2 als auch achter Transistor T8 sind als N-Kanal-MOS-Transistoren realisiert. Daher sind für geringe Versorgungsspannungen kleine, lastseitig über den Transistoren T2, T8 abfallende Restspannungen erzielbar, so daß auch bei geringen Versorgungsspannungen die Verstärkerstufe PA gute Verstärkungseigenschaften aufweist.

Mit der beschriebenen Schaltung, welche bezugspotentialseitig einen Längsregler LR aufweist, können in der Verstärkerstufe Standard-Bauelemente verwendet werden, ohne daß aufgrund hoher Versorgungsspannungen Durchbruchseffekte auftreten. Die Verwendung von Standard-Bauelementen und der Verzicht auf Hochvolt-Technologien ermöglicht bei geringem Aufwand eine kostengünstige Schaltungsrealisierung mit geringer Chipfläche. Da für die Arbeitsfrequenz der Verstärkerstufe, insbesondere beim Betrieb als Hochfrequenz-Verstärkerstufe, der Bezugsknoten BK auf Bezugspotential liegt, hat die Verstärkerstufe PA gute Verstärkungseigenschaften sowie einen großen Aussteuerbereich. Die Verwendung eines N-Kanal-Transistors T2 im Längsregler LR ermöglicht eine leistungslose Ansteuerung des Transistors T2 mittels seiner Gate-Spannung. Die Schaltung ist in einer BiCMOS-Technologie realisierbar, wobei neben den für eine Verstärkerschaltung erforderlichen Kleinsignalschaltungen auch die als Hochfrequenz-Endstufe ausgelegte Verstärkerstufe PA in einen Hochintegrations-Fertigungsprozeß integrierbar ist.

Die beschriebene Schaltung ist in vorteilhafter Weise mit geringem Flächenbedarf und kostengünstig realisierbar, da eine Standard-BiCMOS-Technologie verwendbar ist.

Zudem ermöglicht die leistungslose Ansteuerung der MOS-Transistoren T2, T8 deren Ansteuerung mit geringem Strombedarf.

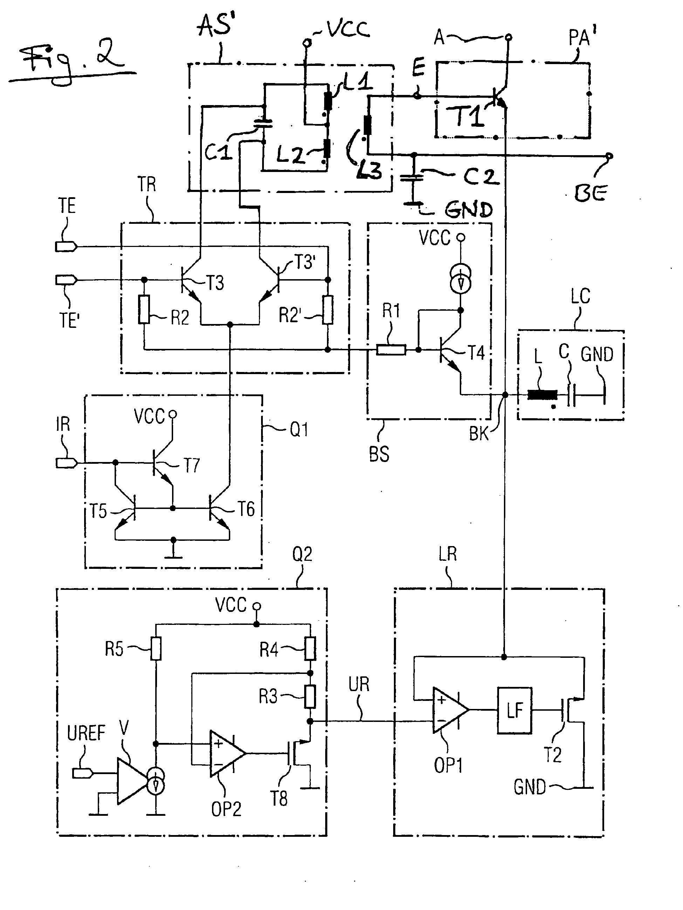

Figur 2 zeigt eine Weiterbildung des vereinfachten Schaltbildes der Verstärkerschaltung gemäß Figur 1. Die Verstärkerschaltung gemäß Figur 2 ist, im Gegensatz zur Schaltung gemäß Figur 1, für ein Eintakt-Ausgangssignal ausgelegt.

Die Schaltung gemäß Figur 2 stimmt in Aufbau und Funktion weitgehend mit der Schaltung gemäß Figur 1 überein und unterscheidet sich von dieser lediglich im Hinblick auf die Verstärkerstufe, die bei Figur 2 mit PA' bezeichnet ist und im Hinblick auf die der Verstärkerstufe PA' vorgeschaltete Anpaßschaltung, welche in Figur 2 als Anpaßschaltung AS' bezeichnet ist, und die eine Eingangs-Treiberstufe TR mit der Ausgangsstufe PA' koppelt.

Die Verstärkerstufe PA' weist einen Bipolar-Transistor T1, ausgebildet als pnp-Leistungstransistor auf, mit einem Emitteranschluß, der mit dem Bezugsknoten BK verbunden ist, mit einem Kollektoranschluß, der mit dem Eintakt-Ausgang A der Verstärkerschaltung gekoppelt ist und mit einem Basisanschluß, der mit dem Eingang E der Verstärkerstufe PA' verbunden ist.

Zur Kopplung des symmetrischen Signalausgangs der Treiberstufe TR mit dem Eintakt-Eingang E der Verstärkerstufe PA' weist die Anpaßschaltung AS' einen integrierten Transformator L1, L2, L3 auf. Dieser Übertrager umfaßt eine Primärseite, welche eine Serienschaltung aus zwei Induktivitäten L1, L2 aufweist, und eine Sekundärseite, welche einen Induktivität L3 aufweist. Die Serienschaltung L1, L2 der Primärseite ist mit dem symmetrischen Ausgang der Treiberstufe TR verbunden. Der gemeinsame Schaltungsknoten der beiden Induktivitäten L1, L2 der Primärseite des Übertragers ist mit einem Versorgungspotentialanschluß VCC verbunden. Ein Parallelkondensator C1, der parallel zur Serienschaltung der Induktivitäten L1, L2 geschaltet ist, bewirkt eine Verbesserung des Frequenzganges des Transformators. Der sekundärseitig am Transformator angeschlossene Eingang E der Verstärkerstufe PA' ist mit einem Anschluß der Induktivität L3 verbunden, deren weiterem Anschluß an einem Bias-Eingang BE ein Ruhestrom zur Speisung des Leistungstransistors T1 zuführbar ist. Dieser Bias-Eingang ist weiterhin über einen Kondensator C2 mit Bezugspotentialanschluß GND verbunden. Der integrierte Transformator L1, L2, L3 faßt das Gegentaktsignal der Vorstufe TR zu einem Eintaktsignal zusammen. Dieser Übertrager L1 bis L3 ist in einfacher Weise mit den in üblichen Halbleiter-Fertigungstechniken vorhandenen drei Metallisierungsschichten realisierbar. Die Ausgangsstufe PA' umfaßt lediglich einen Leistungstransistor T1. Insgesamt bietet die Schaltung gemäß Figur 2 gegenüber der Schaltung von Figur 1 eine vereinfachte Außenbeschaltung, da am Ausgang A ein Eintaktsignal und kein Gegentaktsignal vorliegt.

Die vorteilhafte Wirkungsweise der Spannungsbegrenzung zum Schutz des Transistors T1 vor einem Durchbruch entspricht, wie bereits erwähnt, in Aufbau und Funktion derjenigen von Figur 1.

## Patentansprüche

1. Verstärkerschaltung mit
- einem Bezugspotentialanschluss (GND), an dem ein Massepotential anliegt;
- einer Verstärkerstufe (PA), der an einem Eingang (E, E') ein zu verstärkendes Signal zuführbar ist, an deren Ausgang (A, A') ein verstärktes Signal ableitbar ist und die mit einem Bezugsknoten (BK) gekoppelt ist, der mit dem Bezugspotentialanschluss (GND) verbunden ist,
- einem Längsregler (LR), dem eingangsseitig eine Regelspannung (UR) zugeführt wird und der lastseitig einerseits an den Bezugsknoten (BK) und andererseits mit dem Bezugspotentialanschluss (GND) verbunden ist, wobei der Längsregler eine zwischen Ausgang (A, A') und Bezugsknoten (BK) über die Verstärkungsstufe (PA) abfallende Gleichspannung reduziert, und wobei
- der Längsregler (LR) zur Reduzierung der über die Verstärkerstufe (PA) abfallenden Gleichspannung einen mit der Regelspannung (UR) steuerbaren Widerstand (T2) aufweist, der lastseitig einerseits mit dem Bezugsknoten (BK) und andererseits mit dem Bezugspotentialanschluss (GND) verbunden ist, und
- einem Spannungsregler (Q2), der mit einem Versorgungspotentialanschluss (VCC), an dem ein Versorgungspotential anliegt, verbunden ist und an seinem Ausgang die Regelspannung (UR) bereitstellt, welche eine feste Potentialdifferenz zu dem Versorgungspotential aufweist.

2. Verstärkerschaltung nach Anspruch 1,
**dadurch gekennzeichnet,**
**dass** der steuerbare Widerstand (T2) ein MOS-Transistor ist.

3. Verstärkerschaltung nach Anspruch 1 oder 2,
**dadurch gekennzeichnet,**
**dass** im Längsregler (LR) eine Regelschleife gebildet ist, welche einen ersten Operationsverstärker (OP1) umfasst, dem an seinem invertierenden Eingang die Regelspannung (UR) zuführbar ist, und der mit seinem nicht-invertierenden Eingang mit dem Bezugsknoten (BK) verbunden ist, wobei ein Ausgang des ersten Operationsverstärkers (OP1) mit einem Steuereingang des steuerbaren Widerstands (T2) zu dessen Steuerung gekoppelt ist.

4. Verstärkerschaltung nach Anspruch 3,
**dadurch gekennzeichnet,**
**dass** zwischen Ausgang des ersten Operationsverstärkers (OP1) und Steuereingang des steuerbaren Widerstands (T2) ein Schleifenfilter (LF) vorgesehen ist.

5. Verstärkerschaltung nach einem der Ansprüche 1 bis 4,
**dadurch gekennzeichnet,**
**dass** im Spannungsregler (Q2) ein zweiter Operationsverstärke (OP2) vorgesehen ist, dem an seinem nicht-invertierenden Eingang ein Referenzsignal zuführbar ist, dessen Ausgang auf seinen invertierenden Eingang rückgekoppelt ist, und dessen Eingänge mit dem Versorgungspotentialanschluss (VCC) gekoppelt sind.

6. Verstärkerschaltung nach Anspruch 5,
**dadurch gekennzeichnet,**
**dass** im Spannungsregler (Q2) ein weiterer steuerbarer Widerstand (T8) vorgesehen ist, dessen Steuereingang mit dem Ausgang des zweiten Operationsverstärkers (OP2) verbunden ist, und über dessen gesteuerter Strecke, welche einerseits mit dem Bezugspotentialanschluss (GND) verbunden ist, die Regelspannung (UR) ableitbar ist.

7. Verstärkerschaltung nach einem der Ansprüche 1 bis 6,
**dadurch gekennzeichnet,**
**dass** zwischen Bezugsknoten (BK) und Bezugspotentialanschluss (GND) ein Resonanzkreis (LC) geschaltet ist.

8. Verstärkerschaltung nach einem der Ansprüche 1 bis 7,
**dadurch gekennzeichnet,**
**dass** am Eingang (E) der Verstärkerstufe (PA') ein induktiver Übertrager (L1, L2, L3) angeschlossen ist, der ein eingangsseitig anliegendes Gegentaktsignal in ein Eintaktsignal zur Ansteuerung der Verstärkerstufe (PA) wandelt.

9. Verstärkerschaltung nach einem der vorhergehenden Ansprüche, **dadurch gekennzeichnet,**
**dass** die Verstärkerstufe (PA) mit ihren Ausgängen (A, A') mit dem Versorgungspotentialanschluss (VCC) gekoppelt und somit mit dem Versorgungspotential verbunden ist.

10. Verstärkerschaltung nach einem der vorhergehenden Ansprüche, **dadurch gekennzeichnet,**
**dass** das Versorgungspotential von dem Massepotential verschieden ist.

## Claims

1. Amplifier circuit with
- a reference potential port (GND) with a mass potential;
- an amplifier stage (PA), to which a signal to be amplified can be supplied at an entry (E, E'), wherein at the exit (A, A') thereof an amplified signal can be derived and which is coupled to a reference node (BK), which is connected to the reference potential port (GND),
- a linear regulator (LR), to which a control voltage (UR) is supplied on the entry side and which is connected on the load side on the one hand to the reference node (BK) and on the other hand to the reference potential port (GND), wherein the linear regulator reduces a dc-voltage falling off between the exit (A, A') and reference node (BK) via the amplifier stage (PA), and therein
- the linear regulator (LR) comprises a resistance (T2) being controllable with the control voltage (UR) for reducing the dc-voltage falling off over the amplifier stage (PA), which is on the load side on the one hand connected to the reference node (BK) and on the other hand to the reference potential port (GND), and
- a voltage regulator (Q2), which is connected to a supply potential port (VCC) with a supply potential and which provides the control voltage (UR) at the exit thereof, which comprises a fixed potential difference to the supply potential.

2. Amplifier circuit according to claim 1, **characterized in that** the controllable resistance (T2) is a MOS-Transistor.

3. Amplifier circuit according to claim 1 or 2, **characterized in that** a control loop is formed in the linear regulator (LR), wherein said loop comprises a first operational amplifier (OP1), wherein the control voltage (UR) can be supplied to said operational amplifier at the inverting entry thereof, and which is connected with its non-inverting entry to the reference node (BK), wherein an exit of the first operational amplifier (OP1) is coupled with a control entry of the controllable resistance (T2) for controlling the same.

4. Amplifier circuit according to claim 3, **characterized in that** a loop filter (LF) is provided between the exit of the first operational amplifier (OP1) and the control entry of the controllable resistance (T2).

5. Amplifier circuit according to one of the claims 1 to 4, **characterized in that** a second operational amplifier (OP2) is provided in the voltage regulator (Q2), wherein a reference signal can be supplied to said second operational amplifier at the non-inverting entry thereof, wherein the exit of said second operational amplifier is back-coupled to its inverting entry, and the entries of said second operational amplifier are coupled with the supply potential port (VCC).

6. Amplifier circuit according to claim 5, **characterized in that** a further controllable resistance (T8) is provided in the voltage regulator (Q2), the control entry thereof is being connected to the exit of the second operational amplifier (OP2), and the control voltage (UR) can be derived from the controlled distance of said resistance, which is connected on the one hand to the reference potential port (GND).

7. Amplifier circuit according to one of the claims 1 to 6, **characterized in that** a resonance circuit (LC) is switched between the reference node (BK) and the reference potential port (GND).

8. Amplifier circuit according to one of the claims 1 to 7, **characterized in that** an inductive carrier (L1, L2, L3) is connected to the entry (E) of the amplifier stage (PA'), wherein said carrier converts a counter clock signal being on the entry side into a one clock signal for controlling the amplifier stage (PA).

9. Amplifier circuit according to one of the preceding claims, **characterized in that** the amplifier stage (PA) with the exits (A, A') thereof is coupled to the supply potential port (VCC) and is thus connected to the supply potential.

10. Amplifier circuit according to one of the preceding claims, **characterized in that** the supply potential differs from the mass potential.

## Revendications

1. Circuit amplificateur comportant
- un raccordement de potentiel de référence (GND), au niveau duquel se trouve un potentiel de masse ;
- un étage amplificateur (PA), auquel peut être amené au niveau d'une entrée (E, E') un signal à amplifier, au niveau de la sortie duquel (A, A') un signal amplifié peut être dévié, l'étage amplificateur étant couplé à un noeud de référence (BK) relié au raccordement de potentiel de référence (GND),
- un transformateur avec réglage en phase (LR), auquel est amené, côté entrée, une tension de réglage (UR) et qui est relié, côté charge, d'un côté au noeud de référence (BK) et de l'autre côté au raccordement de potentiel de référence (GND), sachant que le transformateur avec réglage en phase réduit une tension continue chutant par l'intermédiaire de l'étage amplificateur (PA) entre la sortie (A, A') et le noeud de référence (BK), et sachant que
- le transformateur avec réglage de phase (LR) présente une résistance (T2) pouvant être commandée avec la tension de réglage (UR) afin de réduire la tension continue chutant par l'intermédiaire de l'étage amplificateur (PA), la résistance étant reliée, côté charge, d'un côté au noeud de référence (BK) et de l'autre côté au raccordement de potentiel de référence (GND), et
- un régulateur de tension (Q2) relié à un raccordement de potentiel d'alimentation (VCC) au niveau duquel se trouve un potentiel d'alimentation, et fournissant au niveau de sa sortie la tension de réglage (UR), laquelle présente une différence de potentiel fixe par rapport au potentiel d'alimentation.

2. Circuit amplificateur selon la revendication 1,
**caractérisé en ce**
**que** la résistance (T2) pouvant être commandée est un transistor MOS.

3. Circuit amplificateur selon la revendication 1 ou 2,
**caractérisé en ce**
**qu'**une boucle de réglage est formée dans le transformateur avec réglage en phase (LR), laquelle comporte un premier amplificateur opérationnel (OP1), au niveau de l'entrée inverseuse duquel peut être amenée la tension de réglage (UR) et dont l'entrée non inverseuse est reliée au noeud de référence (BK), sachant qu'une sortie du premier amplificateur opérationnel (OP1) est couplée pour sa commande à une entrée de commande de la résistance (T2) pouvant être commandée.

4. Circuit amplificateur selon la revendication 3,
**caractérisé en ce**
**qu'**est prévu, entre la sortie du premier amplificateur opérationnel (OP1) et l'entrée de commande de la résistance (T2) pouvant être commandée, un filtre à boucle (LF).

5. Circuit amplificateur selon l'une quelconque des revendications 1 à 4,
**caractérisé en ce**
**qu'**un deuxième amplificateur opérationnel (OP2) est prévu dans le régulateur de tension (Q2), au niveau de l'entrée non inverseuse duquel un signal de référence peut être amené, dont la sortie est couplée en retour sur son entrée inverseuse, et dont les entrées sont couplées au raccordement potentiel d'alimentation (VCC).

6. Circuit amplificateur selon la revendication 5,
**caractérisé en ce**
**qu'**est prévue dans le régulateur de tension (Q2) une autre résistance (T8) pouvant être commandée, dont l'entrée de commande est reliée à la sortie du deuxième amplificateur opérationnel (OP2), et sur le parcours commandé duquel la tension de réglage (UR) peut être déviée, le parcours commandé étant relié d'un côté au raccordement de potentiel de référence (GND).

7. Circuit amplificateur selon l'une quelconque des revendications 1 à 6,
**caractérisé en ce**
**qu'**un circuit de résonance (LC) est commuté entre le noeud de référence (BK) et le raccordement de potentiel de référence (GND).

8. Circuit amplificateur selon l'une quelconque des revendications 1 à 7,
**caractérisé en ce**
**qu'**un répétiteur inductif (L1, L2, L3) est raccordé à l'entrée (E) de l'étage amplificateur (PA'), lequel répétiteur inductif convertit un signal d'entrée en mode différentiel se trouvant côté entrée en un signal à simple alternance pour commander l'étage amplificateur (PA).

9. Circuit amplificateur selon l'une quelconque des revendications précédentes,
**caractérisé en ce**
**que** l'étage amplificateur (PA) est couplé par ses sorties (A, A') au raccordement de potentiel d'alimentation (VCC) et est ainsi relié au potentiel d'alimentation.

10. Circuit amplificateur selon l'une quelconque des revendications précédentes,
**caractérisé en ce**
**que** le potentiel d'alimentation est différent du potentiel de masse.
